# EUROPEAN PATENT APPLICATION

(11) **EP 3 851 277 A1**
(43) Date of publication of application: **21.07.2021**
(21) Application number: 20214052.1
(22) Date of filing: 15.12.2020
(51) Int. Cl.: B41F 15/18, H05K 3/12, B23K 3/08, B41F 15/08, B41F 17/24, H05K 13/00

(54) **TOOLING PIN PLACEMENT SYSTEM**

(30) Priority: 17.01.2020 GB 202000735
(71) Applicant: ASM Assembly Systems Singapore Pte. Ltd., Singapore 768924 (SG)
(72) Inventor: Falcon, Tom, Yeovil, Somerset BA22 9UT (GB); Pape, Simon Stuart, Yeovil, Somerset BA20 1SE (GB)
(74) Representative: Emerson, Peter James

(57) **Abstract**

A method of removing a magnetic tooling pin from a planar ferromagnetic support surface, comprises providing a pin-placement tool comprising an engagement body and an electrically conductive coil, supplying electrical power to the conductive coil to create a magnetic field which causes the magnetic attraction between the tooling pin and the support surface to be reduced, and moving the engagement body and engaged tooling pin away from the support surface.

## Description

This invention relates to a tooling pin placement system, a printing machine, a placement machine and a method of removing a tooling pin from a planar ferromagnetic support surface.

### Background and Prior Art

Industrial screen-printing machines typically apply a conductive print medium, such as solder paste or conductive ink, onto a planar workpiece, such as a circuit board, by applying the conductive print medium through a pattern of apertures in a printing screen (sometimes referred to as a mask or stencil) using an angled blade or squeegee.

To ensure high quality printing, it is necessary to support the workpiece so that the surface to be printed is parallel to the printing screen, generally horizontal, with the workpiece support being capable of withstanding the pressure placed upon it during the printing operation, especially by the downward pressure applied by the squeegee, while maintaining the correct alignment of the workpiece. The simplest type of support is to use a flat surface or platen on which a workpiece may be placed. However, there are many circumstances where this type of arrangement is not possible, in particular where the underside of a workpiece has previously been printed and equipped with components (for example during a so-called "placement" operation), and this underside needs to be supported during a printing operation applied to the topside of the workpiece. The presence of components on the underside of the workpiece means that the workpiece will not be flat, and also the components are liable to damage if they are "squashed" during a printing operation. It will be appreciated that workpieces also need support during other processes, for example during a placement operation. To this end, specialist support solutions, known as "tooling" is used.

There are currently two common tooling options for providing support for a printed circuit board (PCB) during printing and placement operations:
1) Dedicated tooling blocks - these are blocks whose upper surface is caused, for example by machining, to have a three-dimensional profile designed to accommodate a specific PCB placed thereon. They are relatively expensive, product-specific, and can easily become obsolete when a PCB design changes.
2) Magnetic tooling pins - these are thin columns which are positioned to contact the board in use, avoiding contact with any components (or other delicate or critical regions) on the underside. The pins are magnetic, i.e. they include either a permanent or an electro-magnet within them, to non-permanently attach the pins to a flat, underlying support plate or "tooling table", which may conveniently be made from a magnetically permeable material such as steel. By way of example, ASM currently uses simple, low-cost, moulded plastics tooling pins with a single Neodymium permanent magnet in the base of each pin.

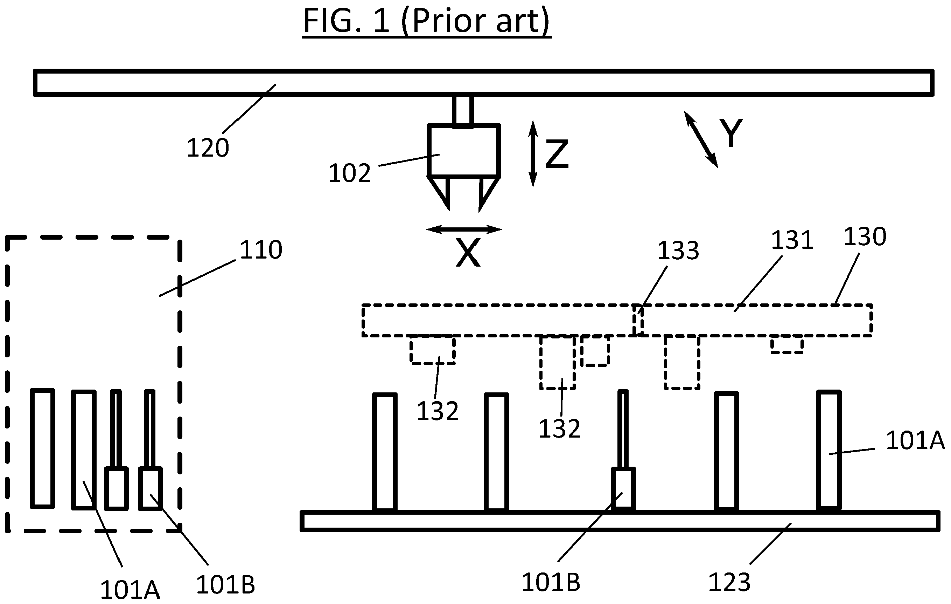

Since tooling pins can be reused for a wide variety of workpieces, they tend to be cheaper and more convenient than dedicated tooling blocks. Within printing machines, tooling pins are usually manually placed on the tooling table (although auto-place systems are starting to be introduced), while placement machines, such as those produced by ASM, may provide both manual placing and auto-place options. With a manual system it is challenging and time consuming for the operator to place the tooling pins consistently and with the required accuracy. Auto-place systems may save time and reduce defects by placing tooling pins accurately. An example of such an auto-place system is schematically shown in FIG. 1. This auto-place system uses a "pin-picker" 102, a device operable to engage with one or more tooling pins 101A, 101B at a time from above, individual tooling pins 101A, 101B being located either on a support surface 123 of a tooling table or in a storage magazine 110. The pin-picker 102 may be movable in the vertical or "Z" direction to engage with and then lift a tooling pin 101A, 101B, and movable in orthogonal "X" and "Y" directions to move the tooling pin laterally into the desired position. The pin-picker 102 may then lower the tooling pin onto the support surface 123 of the tooling table, to which it is magnetically attracted. As shown, the pin-picker 102 is movable in the Z direction with respect to a supporting gantry 120 from which it is suspended, and movable along the gantry 120 in the X direction. Y movement is provided by moving the gantry 120 in the Y direction. Although not shown in FIG. 1, the gantry 120 may be supported within a printing or placement machine. The placed locations of the tooling pins 101A, 101B on the support surface 123 are manually or automatically chosen in dependence of a workpiece 130 to be subsequently supported. The workpiece 130 shown comprises a substrate 131, such as a board or semiconductor wafer, which in this example has a number of features on the underside which hinder support of the workpiece 130. These features may include components 132, vias 133 or the like, as will be understood by those skilled in the art. The location and type of tooling pins 101A, 101B placed on the support surface 123 will depend on the location of such features. In the example shown, tooling pins 101A, which are relatively wide, are used where space between features permits, while relatively thin tooling pins 101B are used where the space between features is small.

One reason why auto-place systems are problematic to implement for printing machines is that within a printing machine, there is generally only one place the pin-picker can be mounted in the printing machine without incurring significant extra cost and complexity, this being the camera gantry. This gantry is critical for ensuring printing machine to PCB alignment accuracy, and so it is important that the auto-place system does not subject the gantry to excess mechanical strain, which might negatively affect accuracy. However, lifting a magnetic tooling pin away from the support plate can lead to such strain. Nevertheless, such "brute-force" approaches have been attempted, with an example being known from GB2306904A, in which a relatively strong electromagnet is used to grip a tooling pin and force it away from the table by overwhelming the relatively weak force between the tooling pin and table created by a permanent magnet located in the base of the pin.

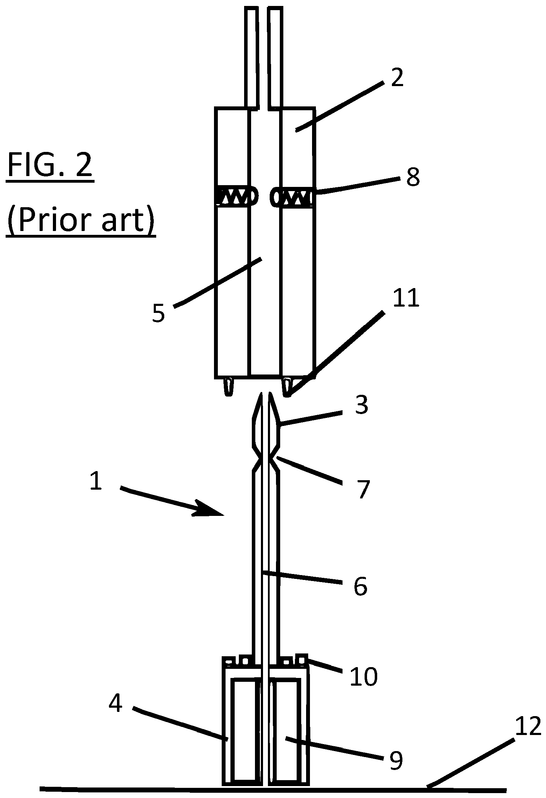

In ASM placement machines, specialised tooling pins have been used which each contain an electro-magnet in the base, with an example of such a tooling pin 1, together with an associated pin-picker 2, being schematically shown in section in FIG. 2. The tooling pin 1 comprises a relatively thin pin body 3, set on top of a base 4, and dimensioned to fit within an internal hollow shaft 5 of the pin-picker 2. A hollow shaft 6 extends throughout the height of the tooling pin 1. A circumferential detent 7 is provided near the top of the pin body 3, for mechanical engagement with a ball latch 8 provided in the pin-picker 2. A electro-magnet 9 is located within the base 4, so that in use the tooling pin 1 is magnetically attracted to a magnetically permeable support surface 12 of the tooling table or storage magazine on which the tooling pin 1 is placed. The electro-magnet 9 has an electrical interface 10 for supplying current to the coil thereof. The electrical interface 10 is adapted to co-operate with a corresponding interface, formed by spring-loaded contact pins 11, located at the lowest extremity of the pin-picker 2.

When placed on the support surface 12, the electro-magnet 9 ensures that the tooling pin 1 is securely fixed to the support surface 12. When it is desired to move the tooling pin 1, the pin-picker 2 is moved into engagement with the tooling pin 1, so that the pin body 3 is received within the hollow shaft 5 and the ball latch 8 mechanically engages with detent 7. At the same time, electrical contact is made between electrical interface 10 and contact pins 11. This enables a current pulse to be applied to the coil of the electro-magnet 9, which acts to nullify the electro-magnet 9, and thus reduce or completely remove the magnetic attractive force between the tooling pin 1 and support surface 12. It is then easy, i.e. only requiring a low lift-force, to lift up the tooling pin 1 with the pin-picker 2, the tooling pin 1 being securely held by the ball latch 8.

When the tooling pin 1 is re-placed, current is removed from the electro-magnet 9 to restore the high holding force. This high holding force exceeds the mechanical coupling force between the ball latch 8 and detent 7, so that when the pin-picker 2 is lifted, the tooling pin 1 remains on the support surface 12.

During a component placement operation, little pressure is put on the PCB, and so only a few tooling pins are required per system. Consequently the complexity of these tooling pins, and the resulting higher cost per tooling pin, is acceptable and ASM's system described above is robust and popular. In a printing operation however, a large number of tooling pins may be required (typically a tooling set would include around 40 pins), and the solution described above becomes prohibitively expensive.

The present invention seeks to overcome these problems, and provide a low-complexity and cost-effective system to enable auto-placement of tooling pins, in particular within printing machines, but also in other applications such as placement machines, solder paste inspection (SPI) machines and dispensing or jetting machines etc.

In accordance with the present invention this aim is achieved by a system including a pin-picker which, contrary to the "brute force" approach described in GB2306904A for example, comprises actuable means to reduce the magnetic holding force of each tooling pin, and thereby to allow easy pin pick-up without causing excess mechanical strain on a supporting structure such as a camera gantry.

In this way, relatively complex and therefore expensive components are all contained within the pin-picker, with the tooling pin only containing the relatively simple, low-cost components.

For the sake of understanding, a "brute force" approach such as described in GB2306904A may be summarised in that a relatively weak force Fp constantly acts between the pin and a support surface, and so to lift that pin, an electromagnet with a relatively strong force Fe between the pin and the electromagnet is used in opposition to Fp, where |Fe| > |Fp|. The electromagnetic force Fe is used to grip the pin, i.e. to attract the pin to a pin picker. When the pin picker is lifted, the pin also lifts since | Fe | > |Fp|.

In contrast, with the present invention, the force Fp between a pin and the support surface is not constant, but instead is selectively reduced by selective application of a second magnetic field, when it is desired to lift the pin (i.e. Fp → Fp(reduced)). A separate latching means, such as a mechanical latch, may be used to releasably attach the pin to a pin-picker. When the pin picker is lifted, the pin also lifts because the mechanical latch grips the pin with a force > Fp(reduced).

### Summary of the Invention

In accordance with a first aspect of the present invention there is provided a tooling pin placement system, comprising:
a tooling table having a planar ferromagnetic support surface at an upper side thereof in use,
a tooling pin comprising:
   a pin body having at an end thereof a head for supporting a workpiece thereon in use, and at a distal end thereof a base which in use rests on the support surface, so that the head is located at the top of the pin body, and
   a pin magnet having an associated magnetic field to magnetically attract the tooling pin to the support surface in use,
a pin-placement tool comprising:
   an engagement body for engaging with the tooling pin during a pin placement operation, and
   an electrically conductive coil,
an electrical supply electrically connected to the conductive coil, and
control means for controlling the electrical supply,
wherein the control means is operable to supply electrical power to the conductive coil to create a magnetic field which causes the magnetic attraction between the tooling pin and the support surface to be reduced.

In accordance with a second aspect of the present invention there is provided a printing machine comprising a tooling pin placement system of the first aspect.

In accordance with a third aspect of the present invention there is provided a placement machine comprising a tooling pin placement system of the first aspect.

In accordance with a fourth aspect of the present invention there is provided a method of removing a tooling pin from a planar ferromagnetic support surface, the tooling pin being magnetically attracted thereto by a pin magnet located in the tooling pin, comprising the steps of:
i) providing a pin-placement tool comprising an engagement body and an electrically conductive coil,
ii) moving the engagement body into engagement with the tooling pin,
iii) supplying electrical power to the conductive coil to create a magnetic field which causes the magnetic attraction between the tooling pin and the support surface to be reduced, and
iv) moving the engagement body and engaged tooling pin away from the support surface.

Other specific aspects and features of the present invention are set out in the accompanying claims.

### Brief Description of the Drawings

The invention will now be described with reference to the accompanying drawings (not to scale), in which:
FIG. 1 schematically shows, in sectional view, a known auto-place system;
FIG. 2 schematically shows, in sectional view, a known tooling pin and pin-picker for use in a placement machine;
FIGs. 3A and 3B schematically show, in sectional view, a tooling pin and part of a pin-placement tool in accordance with a first embodiment of the present invention using a radial permanent pin magnet in separated and engaged configurations respectively;
FIGs. 4A and 4B schematically show, in sectional view, a tooling pin and part of a pin-placement tool in accordance with a second embodiment of the present invention using an axial permanent pin magnet in separated and engaged configurations respectively; and
FIGs. 5A-C schematically show, in sectional view, a tooling pin and part of a pin-placement tool in accordance with a third embodiment of the present invention, during a magnetic latching sequence.

### Detailed Description of the Preferred Embodiments of the Invention

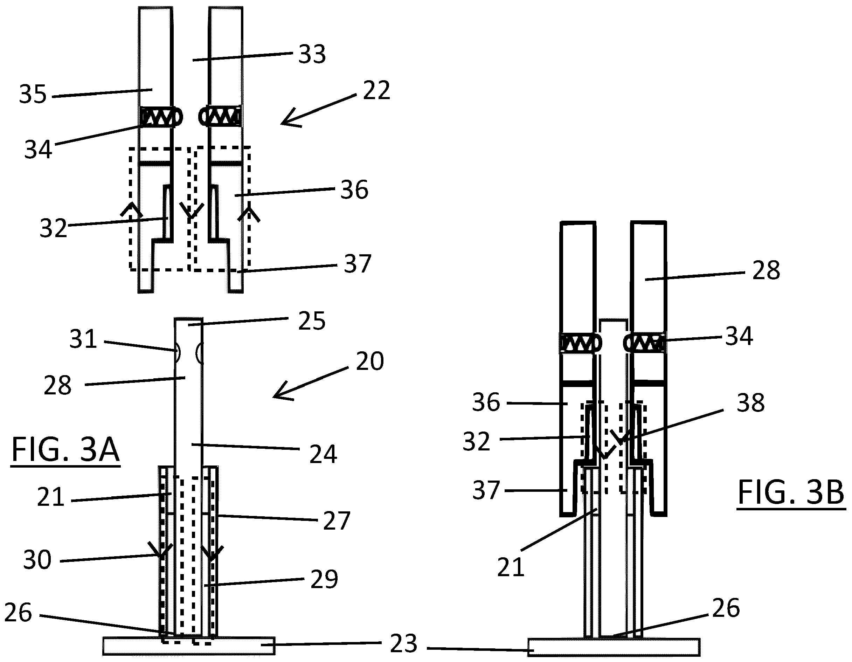

A first embodiment of the present invention is schematically shown in FIGs. 3A and 3B, which show, in sectional view, a tooling pin 20 having a radially-magnetised permanent pin magnet 21 and an engagement body 22 of a pin-placement tool, in separated and engaged configurations respectively.

FIG. 3A shows the tooling pin 20 as it may be positioned during a printing operation for example, resting on and supported by a support surface 23 of a tooling table, the support surface being planar and formed from a ferromagnetic and therefore permeable material, such as steel for example. For clarity, only a small part of the support surface 23 is shown in FIGs. 3A and 3B, and it is to be understood that in practice it may extend over a large enough area to underlie a range of sizes of workpieces and accommodate many tooling pins. The tooling pin 20 comprises a pin body 24, here formed from a rigid and magnetically permeable material, such as steel for example. The permeability of the pin body material may optionally be different to that of the support surface 23. At a top end of the pin body 24 is a head 25 for supporting a workpiece (not shown) thereon in use, and at its lower, distal end, a base 26 which in use rests on the support surface 23, so that the head 25 is located at the top of the pin body 24. The base 26 has a flat end face which in use minimises magnetic circuit reluctance. The pin body 24 includes a lower body section 27, which includes the base 26, and an upper body section 28 which includes the head 25, with the lower body section 27 in this embodiment being of greater thickness than the upper body section 28. The upper body section 28 includes a detent 31 for engaging with the engagement body 22 as will be described in more detail below. The lower body section 27 includes an annular recess 29 which extends from the base 26 and through almost the entire extent of the lower body section 27. It should be noted that the pin body 24 may be integrally or monolithically formed from permeable material, or alternatively formed from a plurality of permeable sub-components, such as a central component which comprises the upper body section 28 and the part of the lower body section 27 which is radially inward of the annular recess 29, and a collar component forming the part of the lower body section which is located radially outwardly of the annular recess 29, joining the central component at the top end of the lower body section 27. The upper end of the annular recess 29 accommodates pin magnet 21, which is of corresponding annular form. Pin magnet 21 is a radially-magnetised permanent magnet, such as a bonded NdFeB grade material, which has an associated magnetic field 30 schematically illustrated in FIG. 3A in dashed lines. As can be seen from FIG. 3A, the magnetic field 30 is substantially constrained to a looped path from the pin magnet 21, through the pin body 24 radially outside the annular recess 29, through a portion of the support surface 23, then through the pin body 24 radially inside the annular recess 29 and back to pin magnet 21. This serves to provide sufficient magnetic attraction between the tooling pin 20 and the support surface 23 to avoid unwanted movement while supporting a workpiece during a printing operation.

The pin-placement tool includes an engagement body 22, for engaging with the tooling pin 20 during a pin placement operation, and which may conveniently be supported from a gantry (not shown) of a placement or a printing machine (not shown), for example from a camera gantry of a printing machine, an electrically conductive coil 32, formed for example from coated copper, housed within the engagement body 22, and various parts not shown in FIG. 3A or 3B for clarity. These include an electrical supply electrically connected to the conductive coil 32, and control means for controlling this electrical supply, and thus operable to supply electrical power to the conductive coil 32. The control means could for example comprise a processor, motherboard, suitably-programmed computer or the like, which may be located remote from the engagement body 22. In addition, a vertical drive for moving the engagement body 22 in a vertical direction towards or away from the support surface 23 may be provided between the engagement body 22 and the supporting gantry. This may configured in a variety of different ways, for example using a linear drive, a ball screw arrangement, or a pneumatic drive, all of which being well-known in the art per se. Furthermore, the pin-placement tool comprises a horizontal drive (not shown) for moving the engagement body 22 in a plane parallel to the support surface 23. This horizontal drive may be provided additionally to the gantry, or form part of the gantry, and may be configured in various ways, or example using a linear drive, a ball screw arrangement, or a pneumatic drive, all of which being well-known in the art per se.

The engagement body 22 shown is generally cylindrical, having a circular hollow shaft 33 extending upwardly from its lower end in use, dimensioned to receive the upper body section 28 of tooling pin 20. An engagement means, in this embodiment a mechanical latch, more particularly a ball latch 34, is provided in the engagement body 22 to protrude into the shaft 33, for latching engagement with the detent 31 of the tooling pin 20 during engagement with the tooling pin 20 during a pin placement operation and thus restraining the tooling pin 20 to the engagement body 22. The engagement body 22 has a two-piece construction, with an upper cylinder 35 formed from a magnetically inert material, such as aluminium, carbon fibre etc, which is mechanically connected to the vertical and horizontal drives and hence the gantry. A lower cylinder 36, which depends from the upper cylinder 35, is formed from a magnetically permeable material, such as steel for example. The conductive coil 32 is mounted within this lower cylinder 36, at a radially inward position, so that it is located proximate to, and vertically above, the pin magnet 21 during engagement (see FIG. 3B). At the lower end of lower cylinder 36 is a flux-guidance element 37 of annular form, which may be provided to direct magnetic flux as required. As shown, the flux-guidance element 37 is dimensioned so as to fit around the uppermost end of the lower body section 27 during engagement with the tooling pin 20. It should be noted that this flux-guidance element 37 is optional only, and, while it may improve performance, is not necessary for the present invention to be achieved.

FIG. 3B shows the engagement body 22 engaging with the tooling pin 20, for example after the engagement body 22 has been moved by the horizontal drive to overlie the tooling pin 20, and then lowered by the vertical drive so that the shaft 33 receives pin body 24 until the ball latch 34 engages with detent 31. In this engaged configuration, the air gap between tooling pin 20 and engagement body 22 is designed to provide an optimum coil current vs release force compromise (see below). When so engaged, the control means is operated to supply electrical power to the conductive coil 32 to create a magnetic field which causes the magnetic attraction between the tooling pin 20 and the support surface 23 to be reduced. When electrical power is supplied to the conductive coil 32, a magnetic field is produced (shown by the dashed lines) by that conductive coil 32 which at least partially counteracts the field produced by the pin magnet 21. If the produced magnetic field is strong enough, it will "overpower" the magnetic field 30 of the pin magnet 21, so that the magnetic flux is effectively constrained within lower cylinder 36. In FIG. 3B, the resulting magnetic field 38 is shown, which very schematically illustrates the resulting flux path. It can be seen that redirecting the flux here causes the magnetic flux in the region of the base 26 and support surface 23 to be reduced, so that the magnetic attraction therebetween is correspondingly reduced. This reduction in magnetic attraction means that the tooling pin 20 can be removed from the support surface 23, for example by lifting the engagement body 22 with the vertical drive, with a reduced release or lifting force.

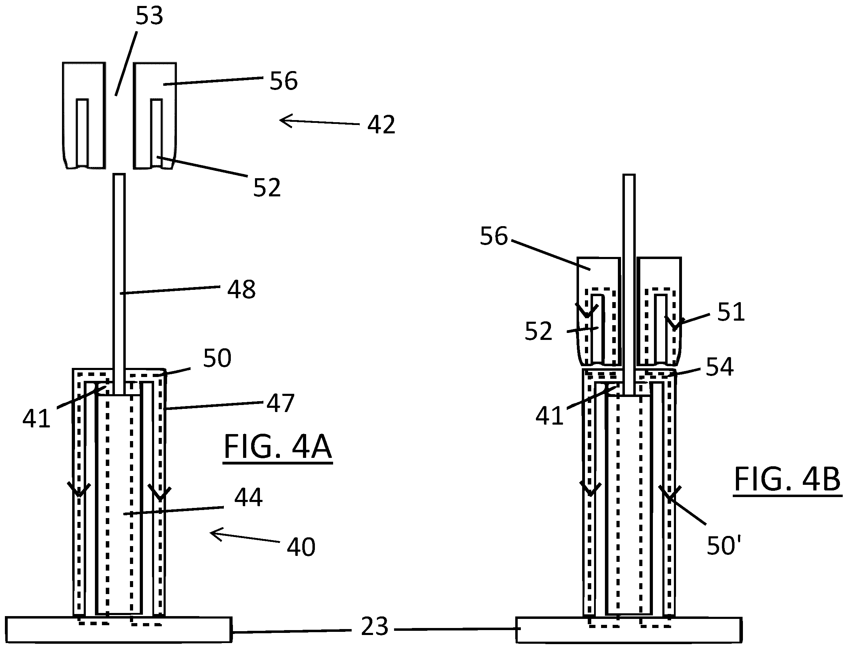

A second embodiment of the present invention is schematically shown in FIGs. 4A and 4B, which show, in sectional view, a tooling pin 40 having an axially-magnetised permanent pin magnet 41 and an engagement body 42 of a pin-placement tool, in separated and engaged configurations respectively. This embodiment is of particular utility where a tooling pin 40 with a relatively thin (for example in comparison to that shown in FIG. 3A) upper body section 48 is required. Many of the components are generally similar to those previously-described with reference to FIGs. 3A and 3B, and so need not be described further here. In particular, for clarity no mechanical latching mechanism is shown.

The pin magnet 41, which could for example be formed from high energy NdFeB, is here axially magnetised, i.e. parallel to the vertical length of the tooling pin 40, to produce an associated magnetic field 50, with flux lines passing vertically through the pin magnet 41, constrained within a lower body section 47, into the support surface 23 and returning through a central pin body 44.

The engagement body 42 comprises a lower cylinder 56 formed from a magnetically permeable material, which forms a central shaft 53 therein, for snugly accommodating the upper body section 48 during engagement. Although not shown for clarity, it is to be understood that other components as previously described with reference to FIG. 3A may also be present. A conductive coil 52 is here mounted within an annular recess set into the lower end of the lower cylinder 56.

As shown in FIG. 4B, when the engagement body 42 and tooling pin 40 are engaged, the conductive coil 52 is operated so that it creates an associated magnetic field 51. It can be seen that in an "opposition" region 54 between the conductive coil 52 and pin magnet 41, the magnetic fields 51 and 50 are in opposition, so that the magnetic field 51 at least partially counteracts that field 50 of the pin magnet 41. In other words, the magneto-motive force (mmf) associated with the conductive coil 52 at least partially cancels that of the pin magnet 41 at the boundary between the tooling pin 40 and engagement body 42. This results in a reduced net magnetic field 50' in the region of the base of the tooling pin 40 and support surface 23, and thereby the magnetic attraction between the tooling pin 40 and the support surface 23 is reduced.

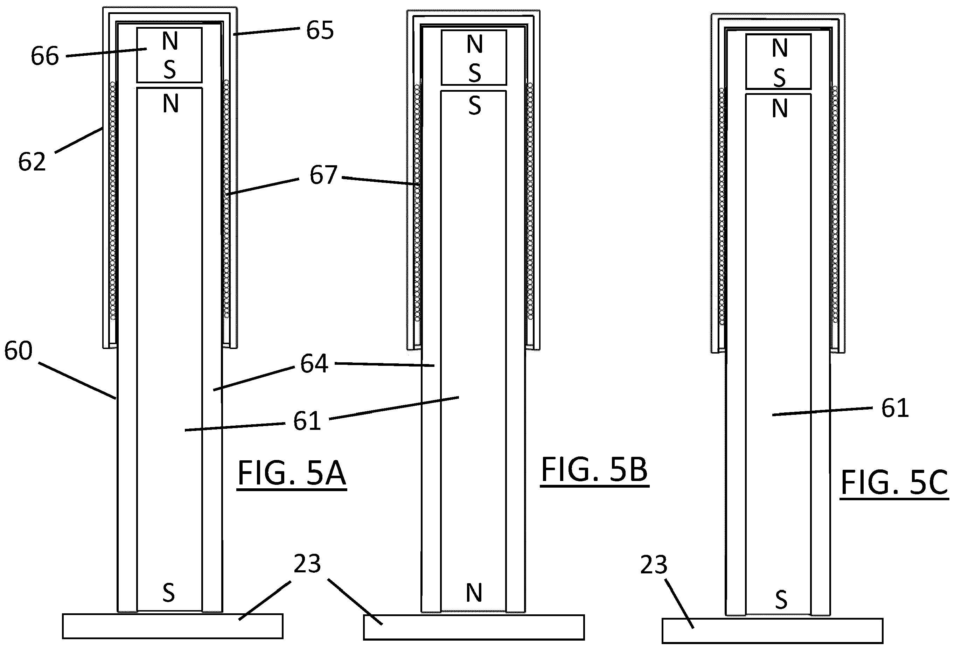

FIGs. 5A-C schematically show, in sectional view, a tooling pin 60 and an engagement body 62, being part of a pin-placement tool, in accordance with a third embodiment of the present invention, during a magnetic latching sequence. Many of the components are generally similar to those previously-described with reference to FIGs. 3A and 3B, and so need not be described further here.

FIG. 5A shows the engagement body 62 and tooling pin 60 in a mutually engaged configuration, in a default state, which would occur for example as soon as the engagement body 62 has been moved into an engaging position with tooling pin 60. The tooling pin 60, which is standing on a support surface 23, here comprises a substantially cylindrical pin body 64, for example formed from a moulded, e.g. an injection-moulded, electro-static dissipative plastics material, which houses a soft magnet 61, such as magnetised steel, at its lower end. As shown, the soft magnet's South pole is located at the lower end of tooling pin 60, the North pole being located closer to the upper end of tooling pin 60, and so the tooling pin 60 is magnetically attracted to the support surface 23. The tooling pin 60 also comprises a hard or permanent magnet 66 which is retained within the cylindrical pin body 64 at the uppermost end of tooling pin 60. As shown, the permanent magnet 66 has its North pole located topmost, and the South pole located at its lower extent.

It can be seen that the soft magnet 61 and hard magnet 66 together constitute a electropermanent magnet (EPM). In the default state, while the tooling pin 60 is not engaged with the engagement body 62 and also as shown in FIG. 5A, the tooling pin 60 is relatively strongly magnetically attracted to support surface 23.

The engagement body 62 comprises a substantially cup-shaped container 65 which may be formed from a magnetically permeable material dimensioned to snugly receive tooling pin 60 within a central shaft thereof during engagement. The shaft of container 65 comprises a conductive coil 67, which is arranged to circumferentially surround an upper portion of the soft magnet 61 during engagement.

If an electrical pulse is fed to the conductive coil 67 by the control means, then the EPM will switch to the configuration shown in FIG. 5B, in which the soft magnet 61 has its polarity reversed with respect to the default state shown in FIG. 5A. In this state, the North pole of soft magnet 61, which is now located at the base of tooling pin 60, is not magnetically attracted to the support surface 23, and so the release or lifting force needed to lift the tooling pin 60 is reduced. The tooling pin 60 may then be lifted and placed in any desired location on the support surface 23. Separate latching means (not shown) would be required to enable lifting to occur. To restore the magnetic attraction between the tooling pin 60 and the support surface 23, a reverse current pulse is applied to the conductive coil 67 by the control means, with the result shown in FIG. 5C that the polarity of the soft magnet 61 reverts to the default state of FIG. 5A.

The above-described embodiments are exemplary only, and other possibilities and alternatives within the scope of the invention will be apparent to those skilled in the art. For example, while the above-described embodiments make use of a mechanical latch, such as a ball latch, to enable the engagement body to lift the tooling pin, other forms of mechanical latch, or indeed non-mechanical latches may be used for this purpose. As a simple alternative, the detent may be provided in the engagement body rather than the tooling pin, with the ball latch provided in the tooling pin to engage with the detent in use. As an example of an alternative mechanical latch, a canted coil spring or the like may be provided either within the tooling pin or the engagement body to engage with a detent in the other of the tooling pin and engagement body. As an example of a non-mechanical latch, by providing suitable coil configurations or a permanent magnet within the engagement body, there may be sufficient magnetic attraction between the tooling pin and engagement body to effect lifting of the tooling pin, at least once the magnetic attraction between the tooling pin and support surface has been reduced as described above.

### Reference numerals used:

1 -Tooling pin
2 - Pin-picker
3 - Pin body
4 - Base
5 - Pin-picker shaft
6 - Pin shaft
7 - Detent
8 - Ball latch
9 - Electro-magnet
10 - Electrical interface
11 - Contact pins
12 - Support surface
20, 40, 60 - Tooling pin
21 - Pin magnet (radially magnetised)
22, 42, 62 - Engagement body
23 - Support surface
24, 64 - Pin body
25 - Head
26 - Base
27, 47 - Lower body section
28, 48 - Upper body section
29 - Annular recess
30, 50 - Magnetic field of pin magnet
31 - Detent
32, 52, 67 - Conductive coil
33, 53 - Shaft
34 - Ball-latch
35 - Upper cylinder
36, 56 - Lower cylinder
37 - Flux-guidance element 38 - Magnetic field (when coil energised)
41 - Pin magnet (axially magnetised)
50' - Reduced magnetic field of pin magnet
51 - Magnetic field of conductive coil
54 - Magnetic field opposition region
61 - Soft magnet
65 - Container
66 - Permanent magnet
101A, 101B - Tooling pins
102 - Pin-picker
110 - Storage magazine
120 - Gantry
130 - Workpiece
131 - Substrate
132 - Components
133 - Via

## Claims

1. A tooling pin placement system, comprising:
a tooling table having a planar ferromagnetic support surface at an upper side thereof in use,
a tooling pin comprising:
a pin body having at an end thereof a head for supporting a workpiece thereon in use, and at a distal end thereof a base which in use rests on the support surface, so that the head is located at the top of the pin body, and
a pin magnet having an associated magnetic field to magnetically attract the tooling pin to the support surface in use,
a pin-placement tool comprising:
an engagement body for engaging with the tooling pin during a pin placement operation, and
an electrically conductive coil,
an electrical supply electrically connected to the conductive coil, and
control means for controlling the electrical supply,
wherein the control means is operable to supply electrical power to the conductive coil to create a magnetic field which causes the magnetic attraction between the tooling pin and the support surface to be reduced.

2. The tooling pin placement system of claim 1, wherein the control means is operable to supply electrical power to the conductive coil to create a magnetic field which, during the pin placement operation, at least partially counteracts that of the pin magnet and thereby reduce the magnetic attraction between the tooling pin and the support surface.

3. The tooling pin placement system of either of claims 1 and 2, wherein the pin magnet comprises a permanent magnet.

4. The tooling pin placement system of claim 1, wherein the pin magnet comprises a non-permanent magnet, and wherein the control means is operable, during the pin placement operation, to supply electrical power to the conductive coil to create a magnetic field to reverse the polarity of the pin magnet and thereby reduce the magnetic attraction between the tooling pin and the support surface.

5. The tooling pin placement system of claim 4, wherein the control means is operable to supply pulses of electrical power to the conductive coil, with each pulse effecting reversal of the polarity of the pin magnet, and wherein the tooling pin further comprises a permanent magnet, such that the pin magnet and permanent magnet together form an electropermanent magnet, with the polarity of the pin magnet latched between each pulse.

6. The tooling pin placement system of any preceding claim, comprising a vertical drive for moving the engagement body in a vertical direction towards or away from the support surface.

7. The tooling pin placement system of any preceding claim, wherein the pin body comprises magnetically permeable material, and the pin magnet is located within a region of the pin body which is spaced from the base.

8. The tooling pin placement system of any preceding claim, wherein the engagement body comprises an engagement means for engaging with the tooling pin during a pin placement operation and restraining the tooling pin to the engagement body.

9. The tooling pin placement system of claim 8, wherein the engagement means comprises a mechanical latch.

10. The tooling pin placement system of any preceding claim, wherein the pin-placement tool comprises a horizontal drive for moving the engagement body in a plane parallel to the support surface.

11. A printing machine comprising a tooling pin placement system of any preceding claim.

12. The printing machine of claim 11 comprising a camera gantry, wherein the pin placement tool is mounted on the camera gantry.

13. A placement machine comprising a tooling pin placement system of any claims 1 to 10.

14. A method of removing a tooling pin from a planar ferromagnetic support surface, the tooling pin being magnetically attracted thereto by a pin magnet located in the tooling pin, comprising the steps of:
i) providing a pin-placement tool comprising an engagement body and an electrically conductive coil,
ii) moving the engagement body into engagement with the tooling pin,
iii) supplying electrical power to the conductive coil to create a magnetic field which causes the magnetic attraction between the tooling pin and the support surface to be reduced, and
iv) moving the engagement body and engaged tooling pin away from the support surface.
